# EUROPEAN PATENT APPLICATION

(11) **EP 4 766 073 A1**
(43) Date of publication of application: **24.06.2026**
(21) Application number: 24307208.9
(22) Date of filing: 19.12.2024
(51) Int. Cl.: H10D 1/60, H01G 4/10, H01G 9/032, H01G 4/012, H01G 4/33, H01G 4/38, H10D 1/68, H01G 4/008, H01G 4/08

(54) **CAPACITOR OR IONIC CAPACITOR, WITH INCREASED INTERMEDIATE REGION THICKNESS IN 2D PORTIONS**

(71) Applicant: Murata Manufacturing Co., Ltd., Nagaokakyo-shi, Kyoto 617-8555 (JP)
(72) Inventor: SALLAZ, Valentin, 14000 CAEN (FR); VOIRON, Frédéric, 14000 CAEN (FR); BUFFLE, Larry, 14000 CAEN (FR); YONEDA, Shingo, KYOTO, 617-8555 (JP)
(74) Representative: Cabinet Beau de Loménie

(57) **Abstract**

An integrated electrical device comprising an energy storage component, comprising:
a support comprising a porous region (103) including a plurality of substantially straight pores (POR) that extend from a top surface of the porous region towards the bottom of the porous region,
an insulating layer (104) having an opening (OP) delimiting a portion of the porous region,
a bottom electrode layer (105),
an intermediate region (106, 1061, 106T, 106T) comprising a dielectric or an ionic conductor, the intermediate region having an inner portion (1061) arranged on an inner portion of the bottom electrode layer and a top portion (106T, 106T') arranged on a top portion of the bottom electrode layer, the inner portion of the intermediate region having a first thickness (T1) and the top portion of the intermediate region having a second thickness (T2) greater than the first thickness,
a top electrode layer (107) arranged on the intermediate region.

## Description

### Field of the Invention

The present invention relates to the field of integration and, more particularly, to electronic products comprising energy storage components such as capacitors or ionic capacitors, and their methods of manufacture.

### Technical Background

Various technologies have been developed for integrating passive components, such as energy storage components, capacitive devices, etc. in/on substrates such as silicon wafers.

There is a general desire to construct integrated energy storage components that provide a high energy storage density. Various approaches have been tried in this regard. In the case of capacitive devices, conventional approaches for increasing capacitance include reducing the thickness of the dielectric layer (subject to the constraint of avoiding dielectric breakdown when the operating voltage is applied) and selecting a material having high dielectric constant as the material of the dielectric layer.

More recently, proposals have been made to form the conductive layers and dielectric layer of an integrated energy storage component conformally over a contoured surface (i.e. forming the conductive layers and dielectric layer so that their shape conforms to the shape of the underlying surface) rather than employing planar layers. Energy storage components of this type may be referred to as "three-dimensional" components (to differentiate them from planar devices). As an example, the PICS technology proposed by Murata Integrated Passive Solutions employs three-dimensional capacitive components and allows high density capacitive components to be integrated into a silicon substrate.

Recently, three-dimensional capacitive components have been fabricated by embedding a Metal-Insulator-Metal (MIM) structure in a porous anodized material, for example in porous anodized alumina (PAA). This technology provides highly-integrated capacitance which can be used for many applications. This technology implements a capacitive stack (for example a MIM stack) in a porous structure which is formed above a substrate such as a silicon wafer. The porous structure may result from the anodization of a thin layer of aluminium deposited above the substrate (e.g. deposited on the substrate or deposited on one or more layers which are themselves formed on the substrate). The anodization process converts the Al into alumina, which is porous (PAA). A mask may optionally be formed over the aluminium layer before anodization takes place, so that the anodization process forms islands of porous material. These components, using a dielectric in the MIM stack, are referred to as capacitors in the present descriptions.

There also exist devices making use of ionic conductors having electronic insulating properties (called ionic conductors in the present application) between electrodes, referred to as ionic capacitors, the ionic conductors are solid-state electrolytes such as LiPON. These ionic capacitors may also be accommodated in a porous anodized alumina structure.

In particular, using solid state electrolytes has been reported to enable planar capacitance densities of around 200-500nF/mm². In such an ionic capacitor, energy is stored via accumulation of mobile charges (ions such as Li+, Na+, etc.) at the electrolyte/electrode interfaces through electrostatic and/or redox processes.

Also, these ionic capacitors may also be accommodated within the pores of a 3D structure so as to increase the capacitance density.

Forming (non-ionic) capacitors or ionic capacitors within the pores of anodic porous oxide, or inside other types of 3D structures, remains difficult to implement.

Usually, above an ionic or non-ionic capacitor formed above a support (for example a porous anodic oxide support), a conductive layer (typically Aluminium) is deposited on the top electrode of the capacitor. This conductive layer is usually delimited by an etching, typically to define an edge outside of a 3D support if one is used. This etching is usually a selective etching configured to stop after etching the top electrode layer on which the conductive layer has been deposited. Ideally, the etching process has no impact on the underlying dielectric or ionic conductor layer.

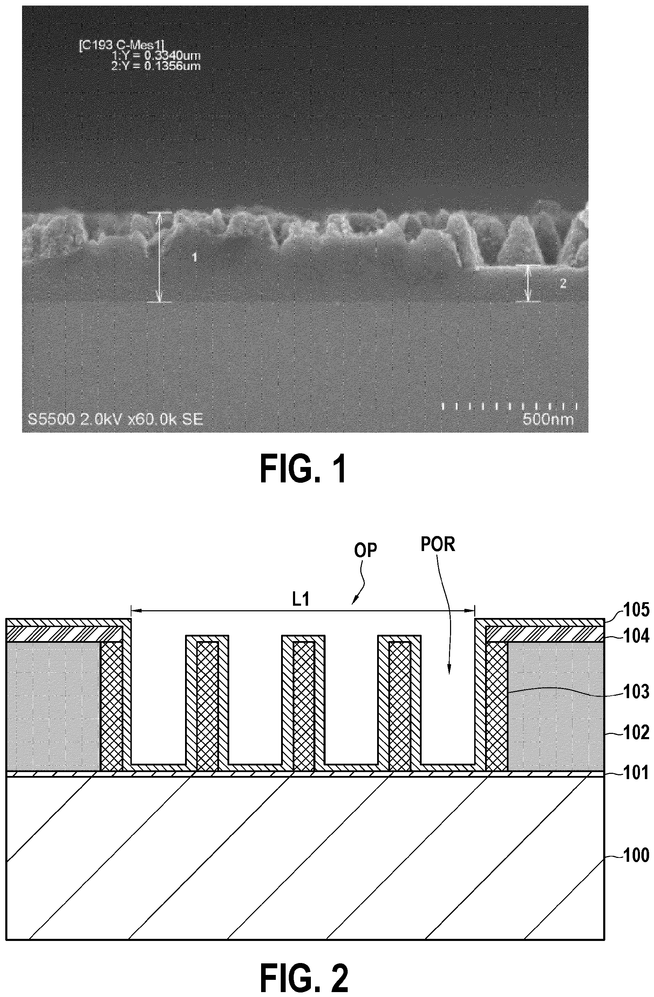

It has been observed, in particular when solid-state electrolytes such as LiPON are used, that the SF6 used to etch the top electrode (typically TiN) can react with the lithium within the LiPON layer and may lead to creating an irregular surface having the aspect of grass. Figure 1 is a SEM image of a such a damaged LiPON layer. Also, these structures have been observed to be LiF-based structures. This implies that the SF6 etching is barely selective, and not suitable for thin layers having a thickness of the order of less than 20nm (such a thickness being suitable for anodic porous oxide devices).

When the intermediate region, for example comprising LiPON layer is damaged, the top and bottom electrode layers may be electrically shorted together, and other undesirable properties may be obtained.

There exists a need for a solution that prevents these undesirable effects from occurring, especially when using thin dielectric or thin ionic conductor layers (less than 20 nanometres).

The invention has been made in the light of the above problems.

### Summary of the Invention

The invention provides an integrated electrical device comprising an energy storage component, comprising:
a support comprising a porous region (for example an anodic porous oxide region) including a plurality of substantially straight pores that extend from a top surface of the porous region towards the bottom of the porous region, the pores having an inner surface inside the pores and a top surface at the level of the top surface of the porous region,
an insulating layer (a continuous layer) having an opening delimiting a portion of the porous region,
a bottom electrode layer having an inner portion arranged on the inner surface of the pores of the portion of the porous region and a top portion arranged on the top surface of the pores of the portion of the porous region and on the insulating layer, and on the top surface of the portion of the porous region,
an intermediate region (a continuous region) comprising a dielectric layer or an ionic conductor (for example a solid-state electrolyte), the intermediate region having an inner portion arranged on the inner portion of the bottom electrode layer (for example, the inner portion is deposited in a conformal manner inside the pores) and a top portion arranged on the top portion of the bottom electrode layer, the inner portion of the intermediate region having a first thickness and the top portion of the intermediate region having a second thickness greater than the first thickness,
a top electrode layer arranged on the intermediate region (for example, the top electrode layer is conformal on the intermediate region).

The bottom electrode layer, the intermediate region, and the top electrode layer form the energy storage component.

For example, the second thickness may be at least 40% greater than the first thickness.

In the above device, the bottom electrode layer, the intermediate region, and the top electrode layer are formed conformally on the layer/region on which they are formed. By conformally, what is meant is that a layer follows the contours of the support onto which it is formed and is not divided into separate portions. For example, the bottom electrode layer follows the contours of the pores of the porous region and extends on the walls of the pores and at the bottom of the pores (the inner surface), and also on the top portions of the pores (the top surface).

The intermediate region is arranged on the top portion of the bottom electrode layer which is arranged on the top surface of the pores and on the insulating layer. Above the insulating layer, there is a thicker separation between the top and the bottom electrode.

Consequently, when a conductive region acting as a current collector is formed, etching this conductive region and the top electrode layer is less likely to electrically short the bottom and top electrode layers together.

According to a particular embodiment, the top portion of the intermediate region comprises a first sub-portion arranged on the top portion of the bottom electrode layer and having the first thickness, and a second sub-portion arranged on the first sub-portion.

In this particular embodiment, the top portion of the intermediate region comprises a stack of the first sub-portion and the second sub-portion. The first sub-portion can be part of a same layer as the inner portion of the intermediate region. This embodiment facilitates obtaining the greater thickness of the top portion of the intermediate region.

By way of example, the first thickness can be of the order of 5 to 6 nm. The thickness of the second sub-portion can be of the order of 2 to 5 nm. Also, the second sub-portion is continuous over each first sub-portion.

According to a particular embodiment, the first sub-portion and the inner portion have a same structure, the same structure being a same material or a same composition of materials or a same stack of materials.

The same composition of materials corresponds to a stoichiometry being maintained between the first sub-portion and the inner portion. This can be obtained by forming the first sub-portion and the inner portion simultaneously in a same layer.

According to a particular embodiment, the first sub-portion and the inner portion on the one hand, and the second sub-portion on the other hand, have a same structure, the same structure being a same material having a different thickness or a same composition of materials having a different thickness or a same stack of materials having a different thickness.

This particular embodiment is advantageous, notably for structures that are sensitive to interface charges or to interface stoichiometry. For example, the embodiment is advantageous for an intermediate region comprising ferroelectric materials or antiferroelectric materials.

According to a particular embodiment, the first sub-portion and the inner portion on the one hand, and the second sub-portion on the other hand, have a different structure.

This particular embodiment allows having a material for the second sub-portion that is chosen for the selectivity it provides during subsequent etchings, for example when etching a subsequently formed conductive region.

According to a particular embodiment, above the insulating layer, the second sub-portion presents an edge.

According to a particular embodiment, the device further comprises a conductive region above and in contact with the top electrode layer, and
wherein the edge of the second sub-portion coincides with an edge of the conductive region and with an edge of the top electrode layer.

This particular embodiment is obtained by a photolithography and an etching defining in a single step the edge of the conductive region, the edge of the top electrode layer, and the edge of the second sub-portion. For example, the selectivity of the etching may be such that the second sub-portion is etched but not the first sub-portion.

According to a particular embodiment, the device further comprises a conductive region above and in contact with the top electrode layer having an edge coinciding with an edge of the top electrode layer, the top portion of the intermediate region extending further than this edge.

This particular embodiment is an alternative to the previously defined embodiment. In this particular embodiment, the second sub-portion is not etched when the conductive region is etched and when the top electrode is etched.

The invention also provides a method of manufacturing an integrated electrical device comprising an energy storage component, comprising:
providing a support comprising a porous region including a plurality of substantially straight pores that extend from a top surface of the porous region towards the bottom of the porous region, the pores having an inner surface inside the pores and a top surface at the level of the top surface of the porous region,
forming an insulating layer having an opening delimiting a portion of the porous region,
forming a bottom electrode layer having an inner portion on the inner surface of the pores of the portion of the porous region and a top portion on the top surface of the pores of the portion of the porous region and on the insulating layer, and on the top surface of the portion of the porous region,
forming an intermediate region comprising a dielectric layer or an ionic conductor, the intermediate region having an inner portion formed on the inner portion of the bottom electrode layer and a top portion formed on the top portion of the bottom electrode layer, the inner portion of the intermediate region having a first thickness and the top portion of the intermediate region having a second thickness greater than the first thickness,
forming a top electrode layer on the intermediate region.

This method can be adapted to the manufacture of the integrated device according to any one of its embodiments.

According to a particular embodiment, forming the intermediate region comprises:
a first deposition to obtain the inner portion of the intermediate region and a first sub-portion arranged on the top portion of the bottom electrode layer and having the first thickness, and
a second deposition to obtain a second sub-portion on the first sub-portion, the first sub-portion and the second sub-portion forming the top portion of the intermediate region.

For example, the first deposition is a conformal deposition, for example using Atomic Layer Deposition (ALD) techniques.

According to a particular embodiment, the second deposition is non-conformal.

This allows the second deposition not to deposit material inside the pores. The process parameters can be selected to obtain this non-conformal deposition resulting in material being only deposited outside of the pores on the top surface which is planar.

According to a particular embodiment, the method further comprises:
- forming a conductive region above and in contact with the top electrode layer,
- performing an etching to form an edge of the conductive region and an edge of the top electrode layer, wherein

the etching has a selectivity with respect to the second sub-portion of the top portion of the intermediate region such that the etching stops when reaching the second sub-portion, or
the etching has a selectivity with respect to the first sub-portion of the top portion of the intermediate region such that the etching stops when reaching the first sub-portion.

### Brief Description of the Drawings

Further features and advantages of the present invention will become apparent from the following description of certain embodiments thereof, given by way of illustration only, not limitation, with reference to the accompanying drawings in which:
- Figure 1, already described, is an image of a damaged LiPON layer,
- Figure 2 is a schematic representation of a support with a bottom electrode layer,
- Figure 3 shows the structure of figure 2 with a first intermediate layer,
- Figure 4 shows the structure of figure 3 with a second intermediate layer,
- Figure 5 shows the structure of figure 4 with a top electrode layer,
- Figure 6 shows the structure of figure 5 with a conductive region,
- Figure 7 shows the structure of figure 6 after an etching, and
- Figure 8 shows an alternative embodiment of the structure of figure 6 after an etching.

### Detailed Description of Example Embodiments

We will now describe energy storage components such as capacitors and ionic capacitors, along with the methods and steps used to obtain these capacitors and ionic capacitors. In particular, we will describe the use of a thicker intermediate region in particular regions.

Figure 2 is an exemplary device comprising a substrate 100. This substrate can comprise a semiconductor region (typically silicon), or also glass or other materials. In particular, the substrate 100 can comprise a conductive layer at the level of its top surface that is configured to act as a current collector.

In the present description, a porous region is formed by anodization of a metal, i.e. it is an anodic porous oxide region. The invention also applies to other types of porous regions.

Above the substrate of figure 2, an anodization barrier layer 101 (tungsten, for example) has been deposited.

On the anodization barrier layer, a metal layer 102, typically comprising aluminium has been deposited. The material of this layer should be selected so as to allow forming straight pores that extend from the top surface of the metal layer to the anodization barrier layer.

Here, a portion of the metal layer has been anodized to obtain straight pores POR inside anodic porous oxide region 103 that extend vertically on the figure so as to reach the anodization barrier layer (as disclosed in document WO 2015/063420). Alternatively, the entire metal layer can be anodized and only a subset of pores will be used to accommodate the subsequently described stack of layers.

An insulating layer 104 has been formed above the metal layer 102. This insulating layer can be formed on the metal layer 102 or on the anodic porous oxide region (in particular if the metal layer has been entirely transformed into anodic porous oxide) or above a hard-mask acting as anodization mask to delimit a portion of the metal layer to be anodized. When deposited above an anodization mask, insulating layer 104 can be analogous to the second hard mask described in document EP 3567645.

An opening OP has been formed in the insulating layer 104, that opens onto a portion of the anodic porous oxide (or that opens onto the entire anodic porous oxide region). This opening has a diameter L1 (its greatest horizontal width).

Above this structure, a bottom electrode layer 105 has been deposited in a conformal manner, for example by ALD. This layer may comprise TiN or other conductive materials. The bottom electrode layer is continuous at this stage, it covers the walls of the pores, the top portion of the pores, the bottom of the pores (where it is in contact with anodization barrier layer 101), and the insulating layer 104. The bottom electrode layer comprises an inner portion located on the inner surface of the pores (i.e. the surface inside each pore including the walls and the bottom of the pore), this inner portion being discontinuous as the inner portions are all separated by another portion referred to as the top portion of the bottom electrode layer. This top portion is located on the top surface of the pores (and therefore separates the sub-portions of the inner portion) and on the insulating layer.

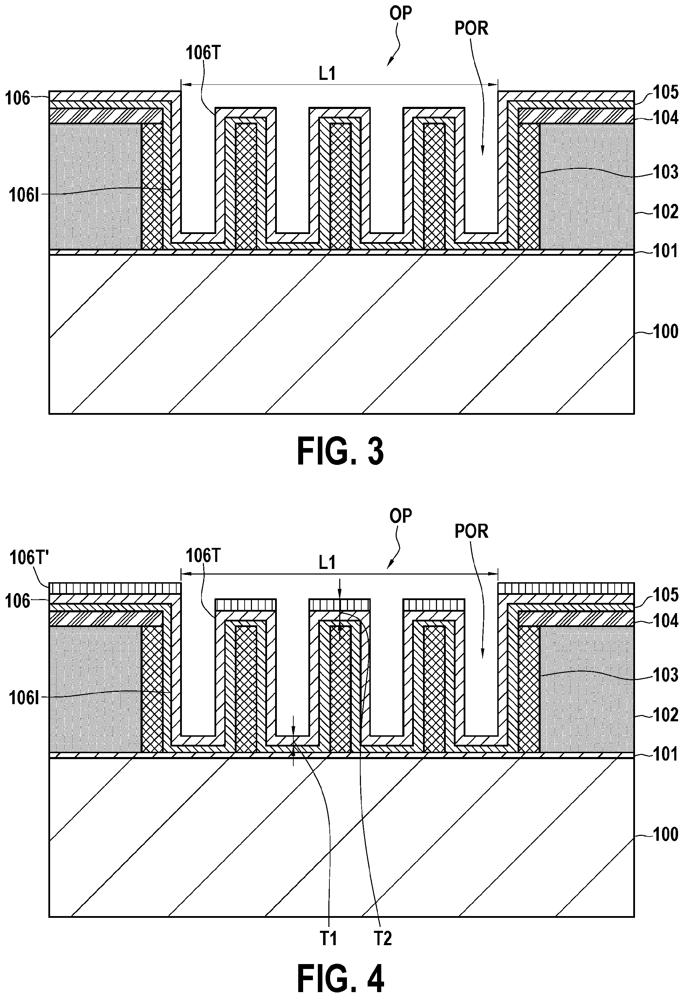

Figure 3 shows the structure of figure 2 after a first step of depositing an intermediate layer 106. This layer has been deposited in a conformal manner (for example by ALD). For example, this layer may comprise at least one material selected from the group including SiN, SiₓO_{y}, AlₓO_{y}, HfₓO_{y}, ZrₓO_{y}, TiₓO_{y}, LiₓP_{y}O_{z}Nₓ₁, LiₓSi_{y}P_{z}Oₓ₁N_{y1}, NₓM'_{y}M"_{z}(Pₓ₁O_{y1})_{z}, with M' and M" being metals from the group comprising Al, Ti, Fe and N being an element from the group comprising Li, Na, K. A combination of these materials may also be considered for the intermediate region.

Intermediate layer 106 is a continuous layer formed over the bottom electrode layer. Intermediate layer 106 comprises an inner portion 106I arranged on the inner portion of the bottom electrode layer and a portion 106T referred to as the first sub-portion 106T arranged on the top portion of the bottom electrode layer. Analogously to the bottom electrode layer, the inner portion 106I is discontinuous and comprises the portion of intermediate layer deposited on the walls and the bottom of the pores already covered by the bottom electrode layer. The first sub-portion 106T of the intermediate layer is located on the top surface of the pores covered by the top portion of the bottom electrode layer and on the insulating layer also covered by the top portion of the bottom electrode layer.

Figure 4 shows the structure of figure 3 after a second step of depositing an intermediate layer. This second step is configured to form this intermediate layer only on the first sub-portion of the intermediate layer to obtain a second sub-portion 106T'. The first sub-portion 106T and the second sub-portion 106T' form a top portion of the intermediate layer (the inner portion and this top portion form an intermediate region). The second sub-portion 106T' can be deposited using a non-conformal deposition technique such that no material is deposited inside the pores covered by the inner portion of the intermediate layer. The person skilled in the art will be able to adapt the parameters of the second step of depositing to obtain this non-conformal deposition, for example through an ALD deposition. By way of example, these parameters may include the pulse time, the exposure/residence time, the purge time, and the pressure.

The inner portion and the first-sub portion of the top portion of the intermediate region are part of a same layer and therefore have a same structure, the same structure being a same material or a same composition of materials or a same stack of materials.

The inner portion and the first-sub portion can have the same structure as the second sub-portion, or a different structure, depending on the application.

Also, the inner portion of the intermediate region has a first thickness T1 (which is also the thickness of the first sub-portion), and the top portion of the intermediate region has a second thickness T2 which is greater than T1 by at least 40%.

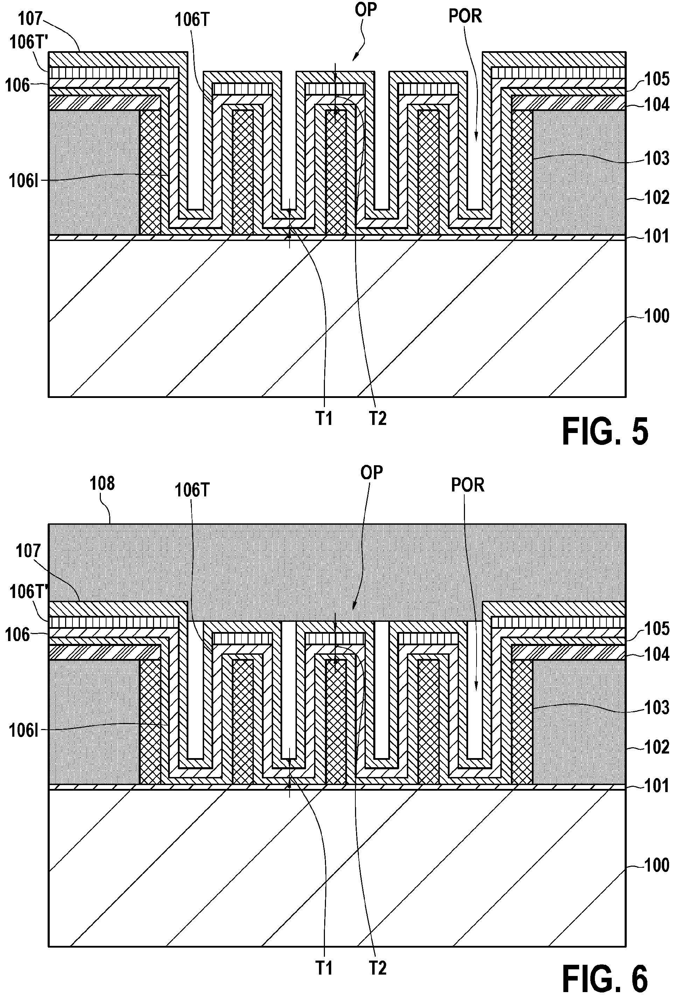

Figure 5 shows the structure of figure 4 after a top electrode layer 107 has been formed on the intermediate region, in a conformal manner (for example by ALD). This top electrode layer may be analogous to the bottom electrode layer and it may also contain TiN. More precisely, top electrode 107 comprises a top portion arranged on the second sub-portion of the top portion of the intermediate region and an inner portion arranged on the inner portion of the intermediate region.

As can be observed on the figure, the top portion of the top electrode layer 107 and the top portion of the bottom electrode layer 107 are spaced apart by the intermediate region having a thickness T2, while the inner portion of the top electrode layer 107 and the inner portion of the bottom electrode layer are spaced apart by the intermediate region having a thickness T1.

The stacks formed by the bottom electrode layers, the intermediate region, and the top electrode layer form an energy storage component such as a capacitor or an ionic capacitor (depending on the material of the intermediate region).

Above the top electrode layer, a conductive layer 108 which may comprise aluminium has been deposited (figure 6).

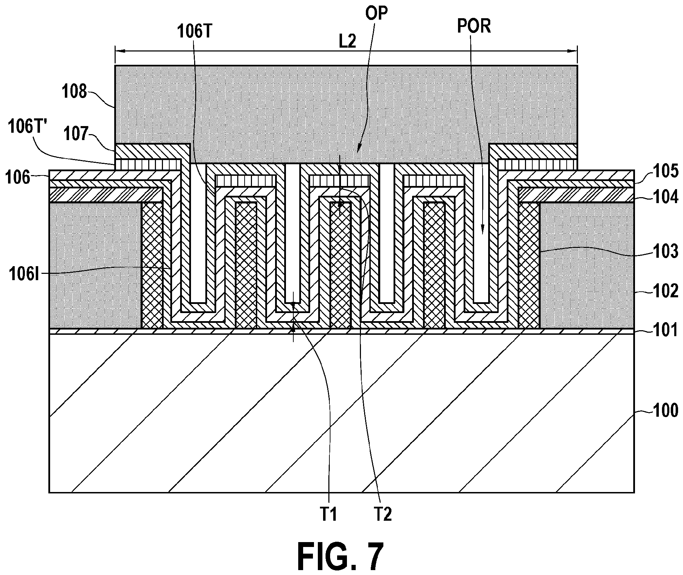

Figure 7 shows the structure of figure 6 in which the conductive layer 108 has been patterned by an etching to delimit a conductive region of the conductive layer 108. In the embodiment of figure 7, the etching stops when reaching the first sub-portion of the top portion of the intermediate region. In other words, the etching and the materials of both the first and second sub-portions are configured to that the etching selectively etches the second sub-portion but not the first sub-portion. In this embodiment, the two sub-portions have a different structure.

Here, the conductive region has a perimeter (for example observed from the top) comprising the perimeter of the portion of the anodic porous oxide region (coinciding with the opening). In other words, the conductive region fully covers the opening, and the conductive region has a diameter L2 which is greater than L1 (described in reference to figure 2).

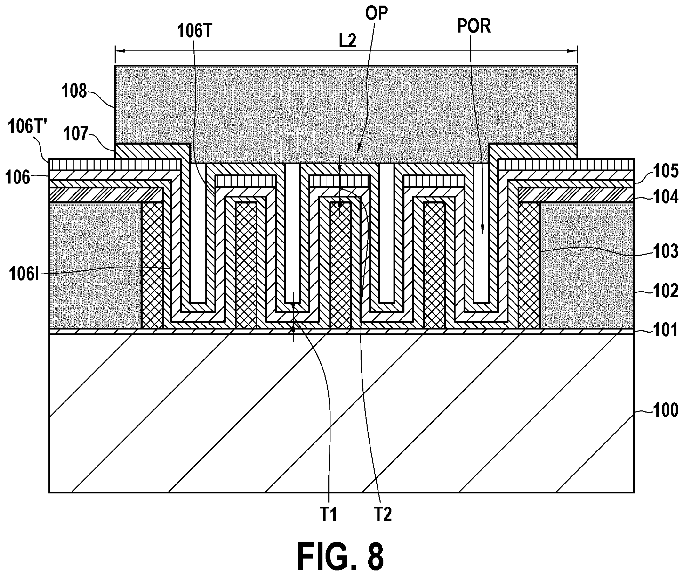

In an alternative embodiment shown on figure 8, the etching stops when the second sub-portion is reached. This embodiment is particularly advantageous for structures that are sensitive to interface charges or to interface stoichiometry. For example, the embodiment is advantageous for an intermediate region comprising ferroelectric materials or antiferroelectric materials.

In the embodiment of figure 7 and in the embodiment of figure 8, the thickness T2 is such that the risk of damaging the intermediate region and electrically shorting the top and bottom electrode layers together is limited.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An integrated electrical device comprising an energy storage component, comprising:
a support comprising a porous region (103) including a plurality of substantially straight pores (POR) that extend from a top surface of the porous region towards the bottom of the porous region, the pores having an inner surface inside the pores and a top surface at the level of the top surface of the porous region,
an insulating layer (104) having an opening (OP) delimiting a portion of the porous region,
a bottom electrode layer (105) having an inner portion arranged on the inner surface of the pores of the portion of the porous region and a top portion arranged on the top surface of the pores of the portion of the porous region and on the insulating layer, and on the top surface of the portion of the porous region,
an intermediate region (106, 106I, 106T, 106T) comprising a dielectric or an ionic conductor, the intermediate region having an inner portion (106I) arranged on the inner portion of the bottom electrode layer and a top portion (106T, 106T') arranged on the top portion of the bottom electrode layer, the inner portion of the intermediate region having a first thickness (T1) and the top portion of the intermediate region having a second thickness (T2) greater than the first thickness,
a top electrode layer (107) arranged on the intermediate region.

2. The integrated device of claim 1, wherein the top portion of the intermediate region comprises a first sub-portion (106T) arranged on the top portion of the bottom electrode layer and having the first thickness, and a second sub-portion (106T') arranged on the first sub-portion.

3. The integrated device of claim 2, wherein the first sub-portion and the inner portion have a same structure, the same structure being a same material or a same composition of materials or a same stack of materials.

4. The integrated device of claim 3, wherein the first sub-portion and the inner portion on the one hand, and the second sub-portion on the other hand, have a same structure, the same structure being a same material having a different thickness or a same composition of materials having a different thickness or a same stack of materials having a different thickness.

5. The integrated device of claim 3, wherein the first sub-portion and the inner portion on the one hand, and the second sub-portion on the other hand, have a different structure.

6. The integrated device of any one of claims 1 to 5, wherein above the insulating layer, the second sub-portion presents an edge.

7. The integrated device of claim 6, further comprising a conductive region (108) above and in contact with the top electrode layer, and
wherein the edge of the second sub-portion coincides with an edge of the conductive region and with an edge of the top electrode layer.

8. The integrated device of any one of claims 1 to 5, further comprising a conductive region above and in contact with the top electrode layer having an edge coinciding with an edge of the top electrode layer, the top portion of the intermediate region extending further than this edge.

9. A method of manufacturing an integrated electrical device comprising an energy storage component, comprising:
providing a support comprising a porous region (103) including a plurality of substantially straight pores (POR) that extend from a top surface of the porous region towards the bottom of the porous region, the pores having an inner surface inside the pores and a top surface at the level of the top surface of the porous region,
forming an insulating layer (104) having an opening (OP) delimiting a portion of the porous region,
forming a bottom electrode layer (105) having an inner portion on the inner surface of the pores of the portion of the porous region and a top portion on the top surface of the pores of the portion of the porous region and on the insulating layer, and on the top surface of the portion of the porous region,
forming an intermediate region (106, 106I, 106T, 106T) comprising a dielectric or an ionic conductor, the intermediate region having an inner portion (106I) formed on the inner portion of the bottom electrode layer and a top portion (106T, 106T') formed on the top portion of the bottom electrode layer, the inner portion of the intermediate region having a first thickness (T1) and the top portion of the intermediate region having a second thickness (T2) greater than the first thickness,
forming a top electrode layer (107) on the intermediate region.

10. The method of claim 9, wherein the forming the intermediate region comprises:
a first deposition to obtain the inner portion (106I) of the intermediate region and a first sub-portion (106T) arranged on the top portion of the bottom electrode layer and having the first thickness, and
a second deposition to obtain a second sub-portion (106T') on the first sub-portion, the first sub-portion and the second sub-portion forming the top portion of the intermediate region.

11. The method of claim 10, wherein the second deposition is non-conformal.

12. The method of any one of claims 9 to 11, further comprising:
- forming a conductive region (108) above and in contact with the top electrode layer,
- performing an etching to form an edge of the conductive region and an edge of the top electrode layer, wherein
the etching has a selectivity with respect to the second sub-portion of the top portion of the intermediate region such that the etching stops when reaching the second sub-portion, or
the etching has a selectivity with respect to the first sub-portion of the top portion of the intermediate region such that the etching stops when reaching the first sub-portion.
